# EUROPEAN PATENT SPECIFICATION

(11) **EP 3 281 233 B1**
(45) Date of publication and mention of the grant of the patent: **02.10.2019**
(21) Application number: 16720166.4
(22) Date of filing: 05.04.2016
(51) Int. Cl.: H01L 31/048, H01L 31/049

(54) **THIN-FILM DEVICE WITH ELECTRICAL ISOLATION LAYER**
DÜNNFILMVORRICHTUNG MIT ELEKTRISCHER ISOLIERSCHICHT
DISPOSITIF À COUCHE MINCE AVEC COUCHE D'ISOLATION ÉLECTRIQUE

(30) Priority: 08.04.2015 US 201562144410 P
(43) Date of publication of application: 14.02.2018
(73) Proprietor: Flisom AG, 8155 Niederhasli (CH)
(72) Inventor: NETTER, Thomas, 8400 Winterthur (CH); OLDRIDGE, John, Canterbury 7630 (NZ); KERN, Roland, 8180 Buelach (CH)
(74) Representative: Parrini, Lorenzo
(86) International application number: PCT/IB2016/000434
(87) International publication number: WO 2016/162742

(56) References cited:
- WO-A1-2014/075058
- US-A1- 2014 326 312

## Description

### BACKGROUND

### Field

Embodiments of the present disclosure generally relate to electrical isolation and structural reinforcement of thin-film photovoltaic devices.

### Description of the Related Art

Photovoltaic devices generally include one or more photovoltaic modules that include arrays of interconnected photovoltaic cells. Photovoltaic modules can be classified according to the materials which are used in the photovoltaic cells. Thin-film photovoltaic cells are an alternative design to the traditional crystalline silicon-based design for photovoltaic cells. Examples of thin-film photovoltaic cells include solar cells including at least one thin-film absorber layer. The thin-film absorber layer may for example comprise one layer of amorphous silicon, cadmium telluride (CdTe), and copper indium gallium selenide (CIGS). Thin-film photovoltaic modules are generally composed of a number of electrically interconnected optoelectronic components, such as photovoltaic cells and additional components, such as diodes and other electronic devices. Thin-film-photovoltaic cells, are generally composed of a stack of three material layers: (1) a conducting back-contact electrode layer, (2) a semiconductive photovoltaic material layer, also known as the absorber, and (3) a conducting front-contact electrode layer, where the front-contact layer is usually transparent.

Document US 2014/326312 A1 discloses a photovoltaic apparatus comprising: a front sheet, a back sheet, and a photovoltaic device disposed between the front sheet and the back sheet. The photovoltaic device comprises an array of photovoltaic cells which array extends in a first direction, wherein the array of photovoltaic cells comprises a first photovoltaic cell and a second photovoltaic cell, and a first serial interconnect having a length that extends in a second direction perpendicular to the first direction, and wherein the first photovoltaic cell and the second photovoltaic cell are electrically connected in series by the first serial interconnect.

Document WO 2014/075058 A1 discloses a photovoltaic module comprising a front sheet, a back sheet, a photovoltaic cell, and a spacing layer disposed between the photovoltaic cell and the back sheet, the spacing layer consisting of silicone in which fiberglass rovings are embedded.

One advantage available when making thin-film photovoltaic devices is the option of using monolithic integration, which is the interconnection of several optoelectronic components on a single substrate. This monolithic integration uses a sequence of layer deposition and scribing techniques to form the individual photovoltaic cells. Photovoltaic cells based on thin-film semiconductive materials, such as CIGS or CdTe, show promise for less expensive solar electricity, lower energy payback time, a greater range of applications, and improved life-cycle impact as compared to traditional wafer-based silicon photovoltaic devices or solar cells. Compared to wafer-based photovoltaic devices, these thin-film monolithic photovoltaic modules may have lower costs thanks to reduced material quantities required to form thin film solar cells, reduced labor costs of monolithic integration, and ease of automatic production of large quantities of photovoltaic modules, such as using roll-to-roll manufacturing techniques.

Another advantage available when making thin-film photovoltaic devices is the option of making the devices flexible. Flexible thin-film photovoltaic devices may be formed by encapsulating a flexible photovoltaic component within layers of polymer and other materials. Flexible photovoltaic devices are ordinarily thinner than glass-encapsulated photovoltaic devices and may be subject to greater stress and strain due to flexing during installation and/or use, which may damage the encapsulated electrical and photovoltaic components.

One problem that can occur with photovoltaic devices, such as thin-film photovoltaic devices is electrical arcs. Electrical arcs can occur during operation of a photovoltaic device, especially when an electrical component becomes damaged due to mechanical stress/strain (e.g., flexing) or the photovoltaic device is not designed correctly. For example, high voltages within an improperly designed photovoltaic device may form and cause unwanted and possibly dangerous electrical arcs. These electrical arcs may form near the bus bars of the apparatus that collects electricity from the formed photovoltaic modules, in the vicinity of electrical connectors or other areas of the periphery of the photovoltaic device, or even from or between components that are ordinarily electrically isolated from the photovoltaic device's electrical components. The electrical arcs may also form between components within the photovoltaic device that are at a different electrical potential, or the electrical arcs may form between the photovoltaic device and nearby components that are not part of the photovoltaic device. Certification of a photovoltaic device typically requires that the photovoltaic device incorporates measures that restrict the occurrence and propagation of electrical arcs. Flexible photovoltaic devices must be able to prevent the occurrence and propagation of electrical arcs even when distorted or flexed into different positions and orientations during installation and/or use. Flexing of the flexible photovoltaic devices will typically occur within the photovoltaic device's weakest or most flexible regions, such as within the region where scribe lines are formed in a solar cell device. Flexing of the photovoltaic device along the scribe lines will affect the desired spacing of regions of adjacent solar cells, which are separated by at least one scribe line, and thus can enhance the likelihood that an arc will occur at these regions. For example, an arc may form between a photovoltaic device and an external object, such as a conductive sheet on which the photovoltaic device is fastened.

Another problem that can occur with photovoltaic devices is degradation due to exposure to the environment and ageing of the materials. For example, variations in thermal conditions, humidity, electrical currents, and the application of mechanical forces contribute to ageing of thin-film photovoltaic devices and may cause defects in the photovoltaic device and its encapsulating materials. This degradation can cause the photovoltaic device to become less efficient as well as fail to maintain its mechanical and electrical properties within certified levels. In the solar industry all photovoltaic devices are required to pass various device certification tests. One will note that the electrical certifications mentioned above are required to prevent electrical arcing within or from the photovoltaic device.

Therefore, there is a need for a thin-film photovoltaic device that incorporates a means to prevent and restrict propagation of electrical arcs, and assure that the formed photovoltaic device will pass all of the required certification testing.

### SUMMARY

Embodiments disclosed herein generally relate to a photovoltaic apparatus and a method of assembling an photovoltaic apparatus. In one embodiment, photovoltaic apparatus is provided including a front sheet, a back sheet, and a photovoltaic device disposed between the front sheet and the back sheet. The photovoltaic device comprises an array of photovoltaic cells which array extends in a first direction, wherein the array of photovoltaic cells comprises a first photovoltaic cell and a second photovoltaic cell. The photovoltaic device further includes a first serial interconnect having a length that extends in a second direction perpendicular to the first direction. The first serial interconnect is disposed between the first photovoltaic cell from the second photovoltaic cell. The first photovoltaic cell and the second photovoltaic cell are electrically connected in series by the first interconnect. The photovoltaic apparatus further includes a spacing layer including a first roving formed of a bundle of fibers disposed between the first interconnect and the back sheet. The first roving has a length that is aligned with the length in the second direction of first serial interconnect.

### BRIEF DESCRIPTION OF THE DRAWINGS

So that the manner in which the above recited features of the present disclosure can be understood in detail, a more particular description of the disclosure, briefly summarized above, may be had by reference to embodiments, some of which are illustrated in the appended drawings. It is to be noted, however, that the appended drawings illustrate only exemplary embodiments and are therefore not to be considered limiting of its scope, and may admit to other equally effective embodiments.
Figure 1A is a cross sectional view of a photovoltaic apparatus, according to an embodiment of the disclosure provided herein.
Figure 1B is a cross sectional view of a photovoltaic apparatus, according to an embodiment of the disclosure provided herein.
Figure 2 is a cross sectional view of a photovoltaic apparatus, according to an embodiment of the disclosure provided herein.
Figure 3A is a partial cross sectional view of a photovoltaic apparatus, according to an embodiment of the disclosure provided herein.
Figure 3B is a partial cross sectional view of a photovoltaic apparatus, according to an embodiment of the disclosure provided herein.
Figure 3C is a partial cross sectional view of a photovoltaic apparatus, according to an embodiment of the disclosure provided herein.
Figure 3D is a partial cross sectional view of a photovoltaic apparatus, according to an embodiment of the disclosure provided herein.
Figure 3E is a partial cross sectional view of a photovoltaic apparatus, according to an embodiment of the disclosure provided herein.
Figure 3F is a partial cross sectional view of a photovoltaic apparatus, according to an embodiment of the disclosure provided herein.
Figure 4 is a top view of a photovoltaic apparatus, according to an embodiment of the disclosure provided herein.
Figure 5 is a top view of a photovoltaic apparatus, according to an embodiment of the disclosure provided herein.
Figure 6 is a top view of a photovoltaic apparatus, according to an embodiment of the disclosure provided herein.
Figure 7 is a top view of a photovoltaic apparatus, according to an embodiment of the disclosure provided herein.
Figure 8 is a process flow diagram of a method for manufacturing one embodiment of a photovoltaic apparatus, according to the disclosure provided herein.

To facilitate understanding, identical reference numerals have been used, where possible, to designate identical elements that are common to the figures. It is contemplated that elements and features of one embodiment may be beneficially incorporated in other embodiments without further recitation.

### DETAILED DESCRIPTION

Embodiments of the present disclosure generally relate to electrical isolation and structural reinforcement of flexible thin-film photovoltaic devices. Embodiments of the present disclosure provide an apparatus and method for forming a photovoltaic module, or photovoltaic apparatus, that contains one or more solar cell containing sub-module assemblies. The photovoltaic apparatus is generally designed to support and retain flexible sub-modules so that they will not become damaged during installation and/or normal use by various human or environmental factors.

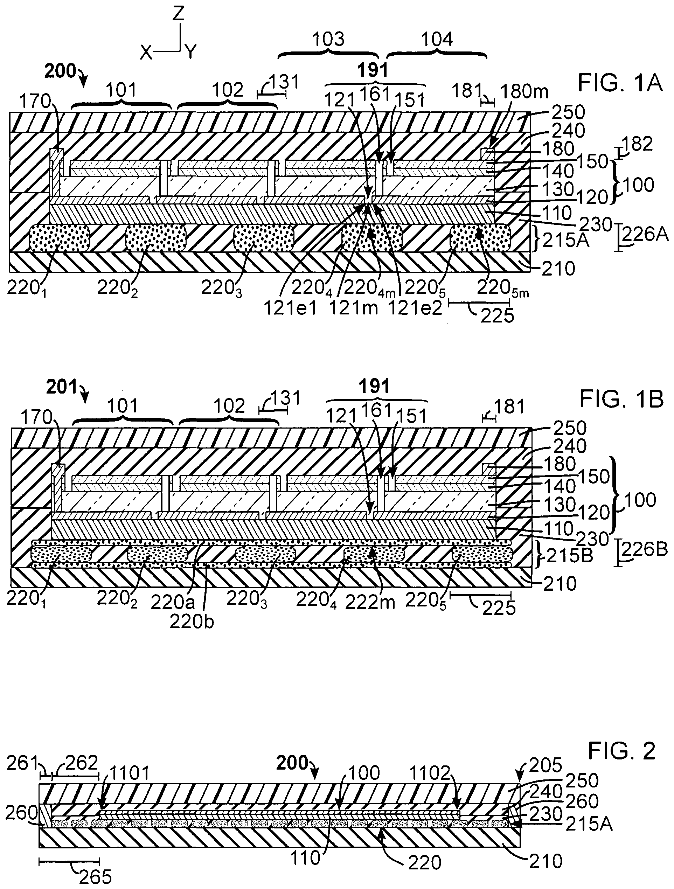

Figure 1A is a cross sectional view a photovoltaic apparatus 200, according to an embodiment of the disclosure provided herein. The photovoltaic apparatus 200 may be encapsulated, for example with one or more thermoplastic polymer materials. The photovoltaic apparatus 200 may include multiple optoelectronic devices, such as photovoltaic devices (e.g., solar cells), diodes, and LEDs. The view in Figure 1A of photovoltaic apparatus 200 is shown including a photovoltaic device 100 (or sub-module) including an array of four photovoltaic cells 101-104 extending from a first end of the photovoltaic device 100 to a second end of the photovoltaic device 100 in the X-direction. More or fewer photovoltaic cells may be included as required by the electrical generation application in which the photovoltaic device(s) will be used. The photovoltaic cells 101-104 are aligned in the X-direction (the first direction) and are interconnected by use of a plurality of scribe lines (i.e., also referred to as P1, P2 and P3 scribe lines), or a plurality of serial interconnects 191, that extend in the Y-direction (the second direction). The layers of each photovoltaic cell 101-104, such as layers 120-150, are formed in stacked orientation in the Z-direction (the third direction). In some applications, the photovoltaic cells 101-104 may also be isolated from additional photovoltaic cells (not shown) that are separated from each other in the Y-direction (the third direction) due to an X-direction isolation scribe line (not shown) that separates the photovoltaic cells to form an X-Y array of photovoltaic cells.

The photovoltaic cells (e.g., photovoltaic cells 101, 102) are electrically connected in series between bus bars 170, 180 by use of the formed scribe lines. Each photovoltaic device 100 is formed on a substrate 110. The substrate 110 may be a rigid substrate or a flexible substrate. The substrate 110 may also be formed from an electrically insulating material. For example, in one embodiment a polyimide substrate may be used, such as a polyimide substrate having a thickness in the Z-direction from about 5 µm to about 200 µm, such as from about 15 µm to about 100 µm.

An electrically conductive back-contact layer 120 may be disposed on a surface of the substrate 110. Back-contact layer 120 can be fabricated from a material having a high optical reflectance and is commonly made of molybdenum (Mo) although several other thin-film materials, such as metal chalcogenides, molybdenum chalcogenides, molybdenum selenides (such as MoSe₂), sodium (Na)-doped Mo, potassium (K)-doped Mo, Na- and K-doped Mo, transition metal chalcogenides, tin-doped indium oxide (ITO), doped or non-doped indium oxides, doped or non-doped zinc oxides, zirconium nitrides, tin oxides, titanium nitrides, titanium (Ti), tungsten (W), tantalum (Ta), gold (Au), silver (Ag), copper (Cu), and niobium (Nb) may also be used or included advantageously. In some embodiments, the back-contact layer is deposited onto the substrate 110 by use of sputtering process.

At least one absorber layer 130 is disposed on the back-contact layer 120. Absorber layer 130 is typically made of an "ABC" material, wherein "A" represents elements in group 11 of the periodic table of chemical elements as defined by the International Union of Pure and Applied Chemistry including copper (Cu) or silver (Ag), "B" represents elements in group 13 of the periodic table including indium (In), gallium (Ga), or aluminum (Al), and "C" represents elements in group 16 of the periodic table including sulfur (S), selenium (Se) or tellurium (Te). An example of an ABC material is the Cu(In,Ga)Se₂ semiconductor also known as CIGS. In some embodiments, the absorber layer 130 may be a polycrystalline material. In other embodiments, the absorber layer 130 may be a monocrystalline material. Another example of a material that may be used as the absorber layer 130 is chalcopyrite.

A semiconductive buffer layer 140 can be disposed on the absorber layer 130. The semiconductive buffer layer 140 ordinarily has an energy bandgap higher than 1.5 eV. The semiconductive buffer layer 140 may be formed of materials, such as CdS, Cd(S,OH), CdZnS, indium sulfides, zinc sulfides, gallium selenides, indium selenides, compounds of (indium, gallium)-sulfur, compounds of (indium, gallium)-selenium, tin oxides, zinc oxides, Zn(Mg,O)S, Zn(O,S) material, or variations thereof.

A front-contact layer 150 may be disposed on the semiconductive buffer layer 140. The front-contact layer 150 can be an electrically conductive and optically transparent material, such as a transparent conductive oxide (TCO) layer. For example, in some embodiments, the front-contact layer 150 may be formed of doped or non-doped variations of materials, such as indium oxides, tin oxides, or zinc oxides. A second busbar 180 may connect to the front-contact layer 150 of one of the photovoltaic cells, such as the photovoltaic cell at one end of an array of photovoltaic cells, for example photovoltaic cell 104.

A first busbar 170 forms an electrical connection to the back-contact layer 120 of the first photovoltaic cell 101. The first busbar 170 may form the cathode of the photovoltaic device 100. In some embodiments, the first busbar 170 may be formed of a flexible material.

The second busbar 180 forms an electrical connection to the front-contact layer 150 of the fourth photovoltaic cell 104. The second busbar 180 may form the anode of the photovoltaic device 100. In some embodiments, the second busbar 180 may be formed of a flexible material. The second busbar 180 may have a width 181 from about 1 mm to about 15 mm, such as from about 3.5 mm to about 4.5 mm, such as about 4 mm. The second busbar 180 may have a thickness 182 from about 5 µm to about 1000 µm, such as from about 50 µm to about 200 µm, such as about 150 µm. The first busbar 170 may have dimensions that are about the same as those of the second busbar 180.

A serial interconnect 191 forms an electrical connection between each adjacent photovoltaic cell 101-104. Each serial interconnect 191 includes a connecting groove 161 (i.e., the P2 scribe line) that is formed through the front contact layer 150, the semiconductive buffer layer 140 and the absorber layer 130 to form an electrically conductive path that electrically connects adjacent photovoltaic cells. The conductive path may be formed by melting a portion of the absorber layer 130 during a laser scribing process used to form the connecting groove 161. For example, one connecting groove 161 electrically connects the front-contact layer 150 of the third photovoltaic cell 103 to the back-contact layer 120 of the fourth photovoltaic cell 104.

Each serial interconnect 191 includes a pair of grooves to electrically isolate portions of each adjacent photovoltaic cell. A back-contact groove 121 (i.e., the P1 scribe line) electrically isolates back-contact layers 120 of adjacent photovoltaic cells, such as photovoltaic cells 103, 104 from each other. A front-contact groove 151 (i.e., the P3 scribe line) electrically isolates front-contact layers 150 of adjacent photovoltaic cells, such as photovoltaic cells 103, 104 from each other. The serial interconnects 191 collectively electrically connect the photovoltaic cells 101-104 in series. A width 131 of the serial interconnect 191 in the X-direction including the width of the back-contact groove 121, the connecting groove 161, and the front contact groove 151 can be from about 50 µm to about 500 µm, such as from about 100 µm to about 250 µm, such as from about 150 µm to about 180 µm. The width of each of the grooves 121, 151 and 161 in the X-direction may be from about 10 µm to about 200 µm, such as from about 20 µm to about 80 µm.

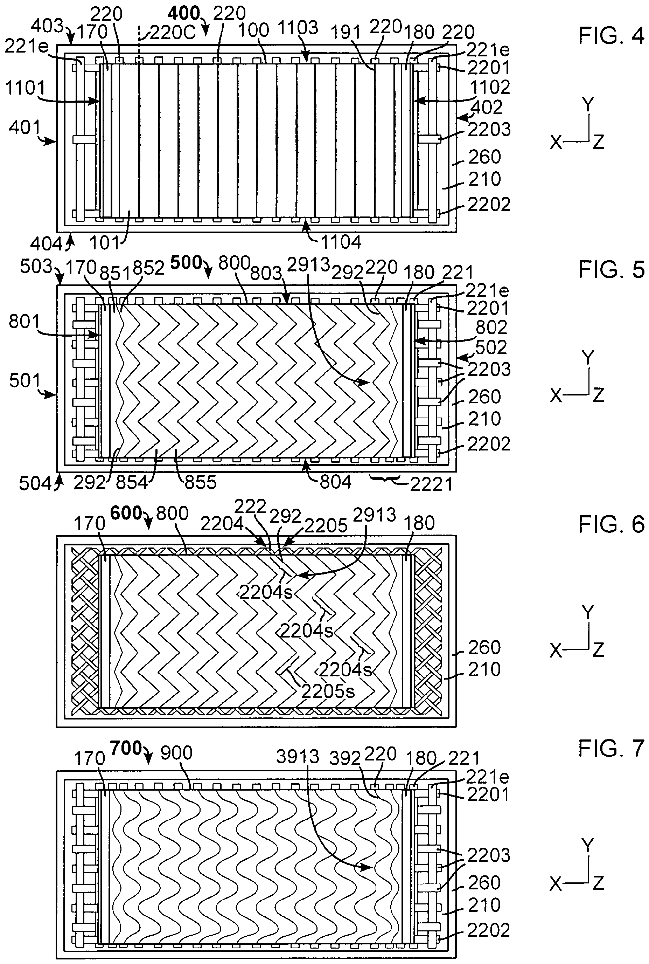

The photovoltaic device 100 may be encapsulated within the photovoltaic apparatus 200 by use of a front-side adhesive 240 and a back-side adhesive 230. In some embodiments, the front-side adhesive 240 and the back-side adhesive 230 completely surround the photovoltaic device 100. The front-side adhesive 240 is formed over the front-contact layer 150 of each of the photovoltaic cells 101-104 of the photovoltaic device 100, and also over the first and second busbars 170, 180. In some embodiments, it is desirable for the front-side adhesive 240 to also fill the front contact grooves 151 between the front-contact layers 150 of the different photovoltaic cells 101-104. The front-side adhesive 240 will also surround all of the edges of the photovoltaic device 100 (i.e., the ends where the first and second busbars 170, 180 are located and edges that are parallel to the X-direction (see Figures 4-7)). The front-side adhesive 240 may be formed of a flexible material, such as a flexible polymer. For example, in one embodiment the front-side adhesive 240 may be formed of a thermoplastic olefin-(TPO) based polymer.

The back-side adhesive 230 is formed on the side of the substrate 110 opposite to the photovoltaic device 100. The back-side adhesive 230 will also surround all of the edges of the photovoltaic device 100 (i.e., the ends where the first and second busbars 170, 180 are located and edges that are parallel to the X-direction). The back-side adhesive 230 may be formed of a flexible material, such as a flexible polymer. For example, in one embodiment the back-side adhesive 230 may be formed of a thermoplastic olefin-based polymer (TPO). The back-side adhesive 230 may contact the front side adhesive 240 at each end of the photovoltaic device 100 (i.e., the ends where the first and second busbars 170, 180 are located) and also on either side of the photovoltaic device 100 (i.e., both sides in the Y-direction of Figure 1A that are not visible in the cross-section of Figure 1A), so that the front-side adhesive 240 and the back-side adhesive 230 completely surround and encapsulate the photovoltaic device 100.

A front sheet 250 can be disposed on an outer surface of the front-side adhesive layer 240, such as a top surface of the front-side adhesive layer 240. The front sheet 250 can be formed of a transparent material, such as glass or a transparent thermoplastic polymer. In some embodiments, the front sheet 250 may be formed of a rigid material. In other embodiments, the front sheet 250 may be formed of a flexible material.

A back sheet 210 can be disposed on an outer surface of the back-side adhesive layer 230, such as a bottom surface of the back-side adhesive layer 230. The back sheet 210 can be formed of a reflective material, such as a metal or a reflective polymer. In some embodiments, the back sheet 210 may be formed of a rigid material. In other embodiments, the back sheet 210 may be formed of a flexible material. In some embodiments, a fiber-reinforced polymer may be used as the material for the back sheet 210. In still other embodiments, the back sheet 210 may be formed of glass material.

The back-side adhesive 230 may include a portion that functions as a spacing layer 215A. The spacing layer 215A can be located between the substrate 110 and the back sheet 210. The spacing layer 215A may be used to ensure that a minimum spacing is maintained between an electrically active component within the photovoltaic apparatus 200, such as the back-contact layer 120 of the photovoltaic device 100, and an external object. Maintaining adequate spacing between electrically active components of the photovoltaic device 100, such as back-contact layer 120, and an external object can help to prevent occurrences of arcing and assure that the formed photovoltaic apparatus 200 will meet photovoltaic device certification standards. Spacing layer 215A may have a thickness 226A in the Z-direction of about 80 µm to about 2 mm, such as about 450 µm to about 1 mm, such as about 450 µm to about 500 µm.

The spacing layer 215A may include a plurality of rovings 220, such as rovings 220₁-220₅. Each roving 220 is formed of a bundle of fibers. The fibers in the rovings 220 may be formed of a fibrous material, such as fiberglass. In other embodiments, the rovings 220 may be formed of another fiber material, such as a carbon fiber material, or of a fabric. In other embodiments, the rovings 220 may be formed of a layer of a unidirectional glass fiber with a non-woven binder. The rovings 220 may have a width 225 in the X-direction of about 50 µm to about 2 cm, such as about 200 µm to about 1 cm, such as about 1.5 mm to about 5 mm.

The rovings 220 can be embedded in the back-side adhesive 230 during a lamination process, which is used to form the photovoltaic apparatus 200. For example, when the photovoltaic apparatus 200 is finally formed the rovings 220 may be separated by sections of back-side adhesive 230 in the X-direction. Furthermore, the rovings 220 generally extend in the Y-direction between the substrate 110 and the back sheet 210. In some embodiments, the rovings 220 can contact the substrate 110 and/or the back sheet 210. Because the rovings 220 can be formed from a rigid material that can be arranged in a desirable structural pattern or orientation, such as fiberglass, the rovings 220 can be used to maintain a spacing between an electrically active component of the photovoltaic device 100, such as the back-contact layer 120, and an external object. Furthermore, a material such as fiberglass generally does not substantially shrink or compress over time, which enables spacing between electrically active components and external objects to be maintained over time in the photovoltaic apparatus 200.

The rovings 220 may be arranged and aligned to structurally support locations where electrical connections are made, such as locations of the first and second busbars 170, 180 at either end of the photovoltaic device 100 as well as the locations of the serial interconnects 191. For example, a fifth roving 220₅ is positioned so that a midline 220₅ₘ of the roving 220₅ in the X-direction of the fifth roving 220₅ substantially aligns with a midline 180m in the X-direction of the second busbar 180. The busbars 170, 180 can be a source of arcing. Thus, it is important that adequate support is provided at the locations of the busbars 170, 180, so that spacing can be maintained between the busbars 170, 180 and an external object over time. For example, because the roving 220₅ is formed of a rigid material, such as fiber glass, the roving 220₅ can structurally support desired portions of the substrate near the busbars 170, 180, which can aid in preventing the occurrences of electrical arcing.

As another example, a fourth roving 220₄ can be positioned so that a midline 220₄ₘ of the fourth roving 220₄ substantially aligns with a midline 121m of a back-contact groove 121. In some embodiments, a roving 220 may be positioned so that a midline (i.e., the center line) of the roving 220 in the X-direction substantially aligns with a midline of a back-contact groove 121 in the X-direction for some or all of each back-contact grooves 121 in the photovoltaic device 100. In other embodiments, a midline of the roving 220 may be aligned with another feature, such as a midline of the connecting groove 161 or the midline of the front contact groove 151. Components of the serial interconnect 191 can be a source of arcing. The back contact groove 121 is the closest component of the serial interconnect 191 to the back sheet 210. Thus, it is important that adequate support is provided at the locations of the back contact groove 121, such as the midline 121m of the back contact groove 121. For example, flexing or bending of the substrate 100 should not affect the spacing between adjacent portions of the back contact layer in adjacent solar cells. As a further example, flexing or bending of the substrate 100 should not affect the spacing between portions of the back contact layer 120, for example of at least one edge 121e1, 121e2 of the back contact layer 120 adjacent to a back-contact groove 121, and the back sheet 210. For example, because the roving 220₄ is formed of a rigid material, such as fiber glass, the roving 220₄ can structurally support desired portions of the substrate, which can aid in preventing the occurrences of electrical arcing.

Figure 1B is a cross sectional view of a photovoltaic apparatus 201, according to another embodiment of the disclosure provided herein. Photovoltaic apparatus 201 is similar to photovoltaic apparatus 200 of Figure 1A except that photovoltaic apparatus 201 includes a spacing layer 215B in place of the spacing layer 215A of photovoltaic apparatus 200. Spacing layer 215B includes the plurality of rovings 220. Although the rovings 220 are given the same reference numbers as the embodiment of Figure 1A, the rovings 220 of photovoltaic apparatus 201 may have different properties, such as size and composition, relative to the rovings 220 in Figure 1A. The spacing layer 215B further includes at least one of a first binder layer 220a and a second binder layer 220b. The first binder layer 220a and the second binder layer 220b can be used to maintain the alignment of the rovings 220, for example in the Y-direction, during and/or after the lamination process has been performed on the photovoltaic apparatus 201. In some embodiments, the rovings 220 are bonded or mechanically attached to one or more of the binder layers 220a or 220b so as to maintain a desired alignment of the rovings 220 in the finally formed photovoltaic apparatus 201. At least one of the binder layers 220a, 220b may be made of a thin sheet of material. For example, one of the binder layers 220a, 220b may be made of a material comprising fibers. A low-cost binder layer may for example include glass fibers. Other examples of binder layer materials may include at least one of carbon fiber, organic fabric, and polymer-based fabric. In some embodiments, the binder layer material may be made of at least one of woven or non-woven fibers. The thickness of at least one binder layer may be from about 5 µm to about 200 µm, such as from about 10 µm to about 50 µm, for example about 15 µm.

Figure 2 is a cross sectional view of a photovoltaic apparatus 202, according to another embodiment of the disclosure provided herein. Photovoltaic apparatus 202 is similar to photovoltaic apparatus 200 of Figure 1A except that photovoltaic apparatus 202 is sized differently (see e.g., the number of rovings 220 is increased relative to the embodiments of Figures 1A, 1B) and photovoltaic apparatus 202 further includes edge seals 260 at opposing ends 1101, 1102 of the photovoltaic apparatus 202. Furthermore, the individual layers of the photovoltaic device 100 are not shown in Figure 2. The edge seals 260 may be disposed between the front sheet 250 and the back sheet 210. The edge seal can fill a region between the front sheet 250 and the back sheet 210 to create the seal. An inner surface (i.e., a surface facing the photovoltaic device 100) of each edge seal 260 may contact the front-side adhesive 240 and the back-side adhesive 230. In some embodiments, an inner surface of each edge seal may further contact one or more rovings 220. The edge seals may be formed of a polymer material, such as butyl. Each edge seal 260 may have a width in the X-direction of about 5 mm to about 50 mm, such as about 6 mm to about 15 mm, such as about 8 mm to about 12 mm, for example about 10 mm.

In some embodiments, the edge seals 260 may be offset in the X-direction from the photovoltaic device 100 by portions of front side adhesive 240, back-side adhesive 230, and spacing layer each having a width 262 in the X-direction. The width 262 may be from about 0 mm to about 50 mm, such as about 2 mm to about 20 mm, such as about 2 mm to about 8 mm. The first and second busbars 170, 180 (see Figure 1A) may be disposed at a distance 265 from the edge of the photovoltaic apparatus 202 (i.e., an outer edge of one of edge seals 260). The distance 265 may be measured from the edge of the photovoltaic device 100 and the outer edge of the photovoltaic apparatus 202 in the X-direction, and is often an important factor in assuring that the formed photovoltaic apparatus 202 will meet photovoltaic device certification standards. The distance 265 may be from about 6 mm to about 50 mm, such as about 8 mm to about 15 mm, for example about 10 mm. The edge seals 260 can provide additional structural support for the photovoltaic apparatus 202 as well as seal the photovoltaic device 100 from the external environment. The edge seals can also help maintain the alignment of the rovings 220 in the photovoltaic apparatus 202 in the X-direction.

In some embodiments, multiple edge seals may completely surround (not shown) the photovoltaic device 100. For example, the edge seals (not shown) may be disposed at opposing ends of the photovoltaic device in the Y-direction, so that electrical isolation and movement of the rovings and other layers in the photovoltaic device in the Y-direction may be prevented. These additional edge seals may have a length in the X-direction that substantially spans the entire length of the photovoltaic apparatus 202 in the X-direction. In other embodiments, one continuous edge seal 260 surrounds the photovoltaic device 100.

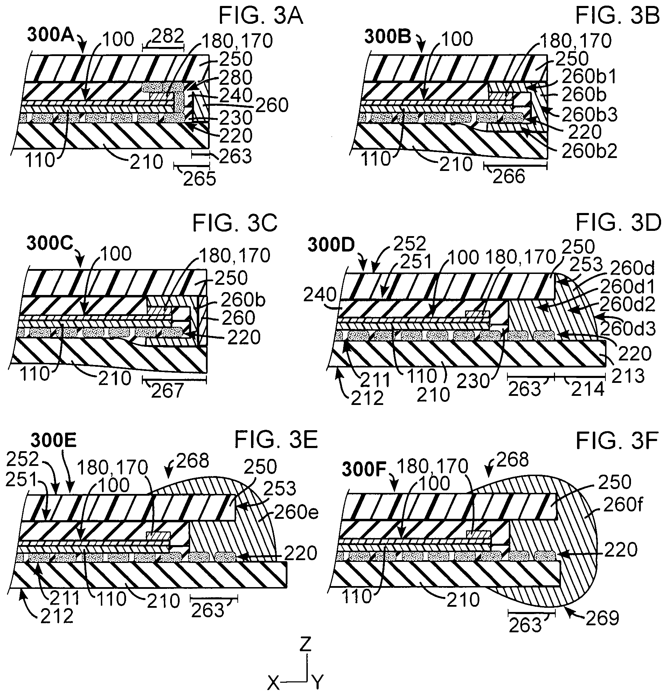

Figure 3A is a partial cross sectional view of a photovoltaic apparatus 300A, according to another embodiment of the disclosure provided herein. Figures 3A to 3F are partial cross sectional views showing only one edge of the photovoltaic apparatus in the X-direction, but the features included in the Figures 3A to 3F can be applied to any of the edges or sides of the photovoltaic apparatus. The X-Y-Z coordinates shown at the bottom of the sheet apply to all of Figures 3A to 3F.

Photovoltaic apparatus 300A is similar to photovoltaic apparatus 202 of Figure 2 except that the photovoltaic apparatus 300A further includes a foldover spacing layer 280. The foldover spacing layer 280 includes additional rovings 220 that at least partially surround the edges of the photovoltaic device 100. It is believed that the foldover spacing layer 280 can be useful to provide a desired spacing (e.g., width 262) between the edge of the photovoltaic device 100 and the edge of the photovoltaic apparatus 300A. The presence of the foldover spacing layer 280 at the edge of the photovoltaic apparatus 300A can help assure that photovoltaic apparatus 300A will meet electrical certification requirements and eliminate a common photovoltaic apparatus manufacturing process yield issue and photovoltaic device failure mode. In some embodiments, at least some of the rovings in the foldover spacing layer 280 may be different than the rovings disposed between the photovoltaic device 100 and the back sheet 210, such as having a different size, density, orientation or composition. In some embodiments, the rovings 220 in the foldover spacing layer 280 may be tightly packed with each other, so that each of the rovings 220 in the foldover spacing layer 280 is in contact with another roving 220 in the foldover spacing layer 280.

Some of the one or more rovings 220 in the foldover spacing layer 280 may be disposed between one of the edge seals 260 and the busbar 170, 180. The one or more rovings 220 disposed between one of the edge seats 260 and the second busbar 180 may contact the busbar 170, 180. In some embodiments, the one or more rovings 220 disposed between one of the edge seals 260 and the busbar 170, 180 may extend in the Z-direction to at least the surface of the busbar 170, 180 that faces the front sheet 250. The one or more rovings 220 between one of the edge seals 260 and the busbar 170, 180 can be used to maintain spacing between the busbars 170, 180 and at least one external object, such as an external object to the side of the photovoltaic apparatus 300A.

Furthermore, in some configurations, the one or more rovings 220 may be disposed between a busbar 170, 180 and the front sheet 250. The one or more rovings 220 disposed between the front sheet 250 and the busbars 170, 180 may contact the busbars 170, 180. The one or more rovings 220 disposed between the front sheet 250 and the busbars 170, 180 may extend past the busbars 170, 180 in the X-direction towards a center of the photovoltaic device 100 in the X-direction. In some embodiments, the rovings only extend to cover part of the busbars 170, 180 in the X-direction. A width 282 of the rovings 220 disposed between the front sheet 250 and the busbar 170, 180 in the X-direction can depend on the width of the busbar 170, 180 in the X-direction. For example, the width 282 can be about 10% to about 400% of the width of the busbar 170, 180 in the X-direction, such as about 25% to about 200% of the width of the busbar 170, 180 in the X-direction, such as about 100% to about 150% of the width of the busbar 170, 180 in the X-direction. The one or more rovings 220 between one of the busbars 170, 180 and the front sheet 250 can be used to maintain spacing between the busbars 170, 180 and external object, such as an external object above the photovoltaic apparatus 300A.

In some embodiments, a photovoltaic apparatus may have a modified foldover spacing layer (not shown) that only includes rovings 220 between the busbars 170, 180 and the edge seal 260 or only between the busbars 170, 180 and the front sheet 250. In this case, due to the smaller amount of roving material used in the photovoltaic apparatus the overall cost of the photovoltaic apparatus will be reduced, while also providing the roving material in areas of the formed photovoltaic apparatus that may, for example, be considered by a person skilled in the art as having a higher probability of arc formation.

Figure 3B is a partial cross sectional view of a photovoltaic apparatus 300B, according to another embodiment of the disclosure provided herein. Photovoltaic apparatus 300B is similar to photovoltaic apparatus 202 of Figure 2 except that the photovoltaic apparatus 300B further includes a U-shaped edge seal 260b in place of the edge seal 260 of the photovoltaic apparatus 202. The U-shaped edge seal 260b will generally surround the edges of the photovoltaic apparatus 300B. It is believed that the U-shaped edge seal 260b can be useful to provide a desired electrical isolation between the edge of the photovoltaic device 100 and external environment positioned outside of the edge of the photovoltaic apparatus 300B. The presence of the U-shaped edge seal 260b at the edge of the photovoltaic apparatus 300B can help assure that photovoltaic apparatus 300B will meet electrical certification requirements and eliminate common photovoltaic apparatus manufacturing process yield issues by providing a desired spacing between the components at the edge of the photovoltaic apparatus 300B. The presence of the U-shaped edge seal 260b at the edge of the device can also increase the likelihood that the photovoltaic device will pass the certification tests and improve the lifetime of the photovoltaic device by increasing the effective path length between the electrical components in the photovoltaic apparatus 300B and the outside environment. The U-shaped edge seal 260b includes a first leg 260b1, a second leg 260b2, and a base 260b3. The U-shaped edge seal 260b may be formed of polyethylene terephthalate (PET) polymer or another thermoplastic polymer. The base 260b3 can extend in the Z-direction as well as the Y-direction. In some embodiments, the base 260b3 may be about the same size and shape as the edge seal 260 of the photovoltaic apparatus 202. The first leg 260b1 can extend from the base 260b3 for a width 266 in the X-direction towards a center of the photovoltaic apparatus 300B in the X-direction between the front sheet 250 and the photovoltaic device 100. The second leg 260b2 can similarly extend the width 266 from the base 260b3 in the X-direction towards a center of the photovoltaic apparatus 300B in the X-direction between the back sheet 210 and the photovoltaic device 100. The first leg 260b1 and the second leg 260b2 of the U-shaped edge seal 260b also extend in the +Y-direction and -Y--direction for the portion shown in Figure 3B. In some embodiments, the first and second legs 260b1, 260b2 of the U-shaped edge seal 260b extend to the inner edge of the busbar 170, 180 in the X-direction. Thus, at least part of the U-shaped edge seal 260b is disposed between the busbar 170, 180 the front sheet 250 and at least part of the U-shaped edge seal 260b is disposed between the busbar 170, 180 and the back sheet 210. In other embodiments, the first and second legs 260b1, 260b2 of the U-shaped edge seal 260b extend past the inner edge of the busbar 170, 180 in the X-direction towards the center of the photovoltaic apparatus in the X-direction.

Figure 3C is a partial cross sectional view of a photovoltaic apparatus 300C, according to another embodiment of the disclosure provided herein. Photovoltaic apparatus 300C is similar to photovoltaic apparatus 202 of Figure 2 except that the photovoltaic apparatus 300C additionally includes the U-shaped edge seal 260b of Figure 3B. The U-shaped edge seal 260b will generally surround the edges of the photovoltaic apparatus 300C. In this embodiment, the edge seal 260 at least partially surrounds the U-shaped edge seal 260b. The presence of the U-shaped edge seal 260b and the edge seal 260 at the edge of the photovoltaic apparatus 300B can help further assure that photovoltaic apparatus 300C will meet electrical certification requirements and eliminate common photovoltaic apparatus manufacturing and photovoltaic device failure modes. In some embodiments, the edge seal 260 fully surrounds the outer perimeter of the U-shaped edge seal 260b. Here, the edge seal 260 may be referred to as an outer seal and the U-shaped edge seal 260b may be referred to as an inner seal. The combined width 267 of the edge seal 260 and the U-shaped edge seal 260b in the X-direction may be the same as the width 266 of the U-shaped edge 260b in the photovoltaic apparatus 300B of Figure 3B. The materials of the edge seal 260 and the U-shaped edge seal 260b may be different in some embodiments.

Figure 3D is a partial cross sectional view of a photovoltaic apparatus 300D, according to another embodiment of the disclosure provided herein. Photovoltaic apparatus 300D is similar to photovoltaic apparatus 202 of Figure 2 except that the photovoltaic apparatus 300D has a back sheet that is longer than the front sheet as well as having a different edge seal configuration. In some configurations of the photovoltaic apparatus 300D, the back sheet 210 is longer than the front sheet 250. The front sheet 250 has a first surface 251 facing the photovoltaic device 100, and a second surface 252 opposite to the first surface 251. The back sheet 210 has a first surface 211 facing the photovoltaic device 100, and a second surface 212 opposite to the first surface 211.

The photovoltaic apparatus 300D includes an edge seal 260d. The presence of the edge seal 260d at the edge of the photovoltaic apparatus 300D can help assure that photovoltaic apparatus 300D will meet electrical certification requirements and eliminate common photovoltaic apparatus manufacturing and photovoltaic device failure modes. In general, the edge seal 260d comprises a polymeric material, such as an elastomer, for example a butyl rubber, that can be formed by dispensing a liquid precursor material along the edge of the photovoltaic apparatus 300D and allowing it to cure. The edge seal 260d includes a first portion 260d1 disposed between the first surface 211 of the back sheet 210 and the first surface 251 of the front sheet 250. The first portion 260d1 can contact the first surface 251 of the front sheet 250 and the first surface 211 of the back sheet 210. An inner surface of the first portion 260d1 may also contact the front-side adhesive 240 and the back-side adhesive 230. The first portion 260d1 may include one or more rovings 220. The one or more rovings 220 in the first portion 260d1 may be used to provide additional structural support and provide a desired spacing within the photovoltaic apparatus 300D. The first portion 260d1 may have a width 263 in the X-direction. The one or more rovings 220 may be placed at various locations along the width 263 of the first portion 260d1.

The back sheet 210 includes an outer portion 213 that extends past the front sheet 250 in the X-direction for a distance 214. The front sheet 250 includes an outer edge 253. The outer edge 253 can extend substantially in the Z-direction to allow the edge seal 260d to form a seal thereon.

The edge seal 260d further includes a second portion 260d2. The second portion 260d2 of the edge seal 260d extends from the first surface 211 of the outer portion 213 of the back sheet 210 to the outer edge 253 of the front sheet 250. In some embodiments, the second portion 260d2 may cover all of the first surface 211 of the outer portion 213 of the back sheet 210. The second portion 260d2 may have an outer curved surface 260d3. The second portion 260d2 may cover all of the outer edge 253 of the front sheet 250. The second portion 260d2 may extend to the second surface 252 of the front sheet 250. In some embodiments, rovings 220 may be included in the second portion 260d2.

Figure 3E is a partial cross sectional view of a photovoltaic apparatus 300E, according to another embodiment of the disclosure provided herein. Photovoltaic apparatus 300E is similar to photovoltaic apparatus 300D of Figure 3D except that the photovoltaic apparatus 300E has a different edge seal configuration. While the photovoltaic apparatus 300D includes an edge seal 260d that extends from the first surface 211 of the outer portion 213 of the back sheet 210 to the outer surface 253 of the front sheet 250, the photovoltaic apparatus 300E includes an edge seal 260e that extends from the first surface 211 past the outer surface 253 of the front sheet 250 to contact the second surface 252 of the front sheet 250. The edge seal 260e includes a front overlap 268 that extends past the second surface 252 of the front sheet 250 in the Z-direction. The front overlap 268 extends back in the X-direction towards a center of the photovoltaic apparatus 300E in the X-direction. The presence of the front overlap 268 of the edge seal 260e will provide an extended path length that the externally supplied contaminants would need to bridge or cross during normal device operation to cause photovoltaic device failure. The front overlap 268 may provide better overall adhesive properties to the edge seal 260e. These better overall adhesive properties may confer a longer lifetime to the edge seal 260e, for example in the context of the daily thermal cycling to which photovoltaic devices may be exposed. The presence of the front overlap 268 can thus help assure that photovoltaic apparatus 300E will meet electrical certification requirements and improve the device lifetime by eliminating a common photovoltaic apparatus failure mode. In some embodiments, the front overlap 268 extends in the X-direction to at least partially overlie the busbar 170, 180. In some embodiments, the front overlap 268 extends in the X-direction to fully overlie the busbar 170, 180. By covering additional surfaces relative to the edge seal 260d of the photovoltaic apparatus 300D, the edge seal 260e may create a stronger seal. In general, the edge seal 260e comprises a polymeric material, such as an elastomer, for example a butyl rubber that can be formed by dispensing a liquid precursor material along the edge of the photovoltaic apparatus 300E and allowing it to cure.

Figure 3F is a partial cross sectional view of a photovoltaic apparatus 300F, according to another embodiment of the disclosure provided herein. Photovoltaic apparatus 300F is similar to photovoltaic apparatus 300E of Figure 3E except that the photovoltaic apparatus 300F has a different edge seal configuration. In addition to the front overlap 268, the photovoltaic apparatus 300F includes a back overlap 269. The back overlap 269 extends past the second surface 212 of the back sheet 210 in the Z-direction. The back overlap 269 extends back in the X-direction towards a center of the photovoltaic apparatus 300F in the X-direction. In some embodiments, the back overlap 269 extends in the X-direction to at least partially underlie the busbar 170, 180. In some embodiments, the back overlap 269 extends in the X-direction to fully underlie the busbar 170, 180. By covering additional surfaces relative to the edge seal 260e of the photovoltaic apparatus 300E, the edge seal 260f may create a stronger seal. In general, the edge seal 260F comprises a polymeric material, such as an elastomer, for example a butyl rubber, and can be formed by dispensing a liquid precursor material along the edge of the photovoltaic apparatus 300F and allowing it to cure.

Figure 4 is a top sectional view of the photovoltaic apparatus 400, according to an embodiment of the disclosure provided herein. The photovoltaic apparatus 400 of Figure 4 as well as the photovoltaic apparatuses of Figure 5 to 7 are shown without the front sheet 250 and the front-side adhesive 240 to give a clearer view of how the rovings, such as rovings 220, are arranged relative to the photovoltaic device. The photovoltaic apparatus 400 extends from a first end 401 to a second end 402 in the X-direction. The photovoltaic apparatus 400 extends from a first side 403 to a second side 404 in the Y-direction.

The photovoltaic device 100 is disposed over the back sheet 210. The photovoltaic device 100 extends from a first end 1101 to a second end 1102 in the X-direction. The individual photovoltaic cells, such as photovoltaic cell 101, extend from a first side 1103 to a second side 1104 of the photovoltaic device 100 in the Y-direction. The serial interconnects 191 divide the solar cells to form an array of serially connected solar cells that extend in the X-direction, as discussed above in conjunction with Figures 1A and 1B. The rovings 220 are disposed between the photovoltaic device 100 and the back sheet 210, as discussed above in conjunction with Figures 1A-1B and 2. As discussed above in conjunction with Figures 1A-2, a centerline 220C of each roving 220, which extends in the Y-direction, is substantially aligned with each serial interconnect 191 that extends in the Y-direction. The serial interconnects 191 can be a source of electrical arcing. For example, an arc may form between a serial interconnect and a conductive sheet or a conductive support on which the photovoltaic device is fastened, for example using adhesive bonding. Thus, a person skilled in the art will take care to maintain spacing between the various differently biased regions within and adjacent to each of the serial interconnects 191 during operation. Therefore, having the centerline 220C of the rovings 220 aligned with each serial interconnect 191 will support this relatively flexible region of the photovoltaic device 100 so that the spacing between the various separated portions of the serial interconnects 191 and other nearby electrically conductive parts can be maintained, and thus electrical arcing within or emanating from the photovoltaic device 100 can be prevented.

One or more outer rovings 221e are disposed at a position in the X-direction between an end of the photovoltaic device 100 and the adjacent end of the photovoltaic apparatus 400. For example, an outer roving 221e is disposed between the first end 1101 of the photovoltaic device 100 and the first end 401 of the photovoltaic apparatus 400. The outer rovings 221e can provide additional support in the outer areas of the photovoltaic apparatus 400, and in some cases be part of a foldover spacing layer 280 (see Figure 3A).

Furthermore, the outer rovings 221e can strengthen the bonding of edge seals (e.g., the edge seals of Figures. 3B to 3F) to at least one of the front sheet 250, the back sheet 210, the front-side adhesive 240, and the back-side adhesive 230. The outer rovings 221e can strengthen the bonding of the edge seals by taking advantage of the fact that the thermal expansion coefficient of the rovings is lower than that of other components of the photovoltaic apparatus 400. Furthermore, the outer rovings 221e can prevent fluid slippage, deformation, and displacement of components, for example adhesives, that may be caused, for example, by increased temperatures during operation of the photovoltaic apparatus. The outer rovings 221e can also provide similar benefits at other locations of the photovoltaic apparatus 400.

The photovoltaic apparatus 400 further includes longitudinal rovings 2201-2203. The longitudinal rovings 2201-2203 can each extend from a location in the X-direction between the first end 401 of the photovoltaic apparatus 400 and the first end 1101 of the photovoltaic device 100 to a location in the X-direction between the second end 402 of the photovoltaic apparatus 400 and the second end of the 1102 of the photovoltaic device 100. A first longitudinal roving 2201 can be aligned with the first side 1103 of the photovoltaic device 100 and disposed between the first side 1103 of the photovoltaic device 100 and the back sheet 210. A second longitudinal roving 2202 can be aligned with the second side 1104 of the photovoltaic device and disposed between the second side 1104 of the photovoltaic device 100 and the back sheet 210. A third longitudinal roving 2203 can be disposed at an intermediate location between the first longitudinal roving 2201 and the second longitudinal roving 2202. In some embodiments, additional longitudinal rovings may be included. The longitudinal rovings 2201-2203 that extends in the Y-direction may underlie or overlie in the Z-direction the rovings 220 that extend in the X-direction. In some embodiments, one or more of the longitudinal rovings and may partly overlie some of the rovings 220 and underlie the remainder of the rovings 220. For example, one or more of the longitudinal rovings may alternate between being disposed above and below the rovings 220 as the longitudinal rovings 2201-2203 extend in the X-direction to create a weaving pattern between the longitudinal rovings 2201-2203 and the rovings 220.

Figure 5 is a top sectional view of the photovoltaic apparatus 500, according to an embodiment of the disclosure provided herein. Photovoltaic apparatus 500 is similar to photovoltaic apparatus 400 of Figure 4 except that the photovoltaic apparatus 500 includes a different photovoltaic device that has differently configured serial interconnects 292 and a different arrangement of rovings. The photovoltaic apparatus 500 extends from a first end 501 to a second end 502 in the X-direction. The photovoltaic apparatus 500 extends from a first side 503 to a second side 504 in the Y-direction.

The photovoltaic apparatus 500 includes a photovoltaic device 800. The photovoltaic device 800 is disposed over the back sheet 210. The photovoltaic device 800 extends from a first end 801 to a second end 802 in the X-direction. The photovoltaic device 800 extends from a first side 803 to a second side 804 in the Y-direction. The photovoltaic device 800 includes a plurality of solar cells, such as photovoltaic cells 851, 852, separated from each other in the X-direction by a serial interconnect 292. The serial interconnects 292 generally include the same scribe lines (e.g., grooves 121, 151, and 161) as the serial interconnects 191, and the scribe lines are similarly spaced apart relative to each other. As illustrated in Figure 5, the serial interconnects 292 are formed in a sawtooth pattern to separate individual solar cells in the photovoltaic device 800. Figures 5 to 7 provide examples of serial interconnects that can be arranged in a periodic pattern with peaks spaced apart in the X-direction. Each serial interconnect 292 may have a plurality of sawtooth points 2913 (i.e., peaks in the X-direction) at which the serial interconnect 292 sharply changes direction. Photovoltaic apparatus 500 includes the longitudinal rovings 2201 and 2202 like the photovoltaic apparatus 400. In contrast to the photovoltaic apparatus 400, the photovoltaic apparatus includes a plurality of intermediate longitudinal rovings 2203 between the longitudinal rovings 2201 and 2202. The intermediate longitudinal rovings 2203 may be disposed to extend in the X-direction and position to underlie a plurality of the sawtooth points 2913 of the different serial interconnects 292. In some embodiments, an intermediate longitudinal roving 2203 underlies each sawtooth point 2913 in the photovoltaic device 800.

Photovoltaic apparatus 500 also includes the rovings 220, which extends in the Y-direction, like the photovoltaic apparatus 400. In contrast to the photovoltaic apparatus 400, the photovoltaic apparatus 500 includes rovings 220 that are disposed to extend in the Y-direction and are positioned to underlie a plurality of the sawtooth points 2913 of the serial interconnects 292. In some embodiments, a roving 220 underlies at least half of the sawtooth points 2913 in a serial interconnect 292 of the photovoltaic device 800, and thus two rovings 220 can be used to support each serial interconnect 292. The sawtooth points 2913 can be a source of electrical arcing, and the intermediate longitudinal rovings 2203 as well as the rovings 220 can provide support at the locations of the sawtooth points 2913, so that the spacing between a portion of serial interconnect 292, for example a sawtooth point 2913, and another conductive part, for example a conductive surface of the back sheet 210 or a conductive surface to which the photovoltaic apparatus 500 is bonded, remains greater than a certain distance, for example a distance set by certification authorities.

The sawtooth pattern of the serial interconnects 292 may vary along the X-direction. For example, the serial interconnects 292 closer to the center of the photovoltaic device 800 than to the ends 801, 802 of the photovoltaic device 800 may have different properties (e.g., saw-tooth shape, distance apart, etc.) than the serial interconnects 292 that are closer to the ends 801, 802 of the photovoltaic device 800. These different properties may include variations in the sharpness of the angles in the different serial interconnects 292 as well as variations in the peak to peak amplitude of the different serial interconnects (i.e., the distance in the X-direction between adjacent peaks in the sawtooth pattern of a given serial interconnect). For example, the photovoltaic device 800 may include one or more regions 2221 bordering one of the busbars 170, 180 in which the serial interconnects 292 have a reduced peak to peak amplitude relative to the serial interconnects 292 not in one of the one or more regions 221.

Figure 6 is a top sectional view of a photovoltaic apparatus 600, according to an embodiment of the disclosure provided herein. Photovoltaic apparatus 600 is similar to photovoltaic apparatus 500 of Figure 5 except that the photovoltaic apparatus 500 includes a different arrangement of rovings. The photovoltaic apparatus 600 includes the photovoltaic device 800 that is also included in the photovoltaic apparatus 500. In the photovoltaic apparatus 500, the rovings 220 are aligned along the Y-direction and the longitudinal rovings 2201-2203 are aligned along the X-direction. Conversely, in the photovoltaic apparatus 600, the rovings are oriented at oblique angles relative to the X-direction and the Y-direction. For example, a first set of rovings 2204 may be oriented at negative 45 degrees relative to the X-direction (i.e., a horizontal axis), and a second set of rovings 2205 may be oriented at positive 45 degrees relative to the X-direction. Other oblique angles besides 45 degrees may also be used. The rovings 2204, 2205 can be arranged in a weave pattern. For example, a given roving 2204 may alternate along the length of the given roving 2204 between underlying and overlying the rovings 2205 that the given roving 2204 passes.

In some embodiments, the rovings 2204, 2205 may be oriented to be parallel to portions of at least some of the serial interconnects 292. For example, the serial interconnects 292 can include linear segments 2204s and 2205s between sawtooth points 2913. The rovings 2204 can be aligned parallel to the linear segments 2204s, and at least some of the rovings 2204 may be positioned to underlie one or more of the linear segments 2204s. The rovings 2205 can be aligned parallel to the linear segments 2205s, and at least some of the rovings 2205 may be positioned to underlie one or more of the linear segments 2205s. For example, the linear segments 2204s, 2205s that are not in the region 2221 (i.e., the region having the reduced peak to peak amplitude) may each have an underlying roving 2204, 2205. As discussed above in reference to Figure 5, the sawtooth points 2913 can be a source of electrical arcing, but arcing may still occur from other locations of the serial interconnects 292 besides the sawtooth points 2913. The rovings 2204, 2205 of the photovoltaic apparatus 600 can be arranged to underlie the entire length of the serial interconnects 292, which can further provide increased support for the serial interconnect 292 regions in order to maintain spacing between the various portions of the serial interconnects 292 to prevent electrical arcing.

Figure 7 is a top sectional view of a photovoltaic apparatus 700, according to an embodiment of the disclosure provided herein. Photovoltaic apparatus 700 is similar to photovoltaic apparatus 500 of Figure 5 except that the photovoltaic apparatus 500 includes a different photovoltaic device. Photovoltaic apparatus 700 includes a photovoltaic device 900. The photovoltaic device 900 is similar to the photovoltaic device 700 except that the photovoltaic device 900 includes serial interconnects 392 having a wavy pattern instead of the serial interconnects 292 having the sawtooth pattern of photovoltaic device 800. The serial interconnects 392 generally include the same scribe lines (e.g., grooves 121, 151, and 161) as the serial interconnects 191, and the scribe lines are similarly spaced apart relative to each other. The wavy pattern can take a variety of forms including a periodic curve, a quasi-periodic curve, or a sine wave pattern. The serial interconnects 392 may have different properties along the X-direction. For example, the serial interconnects 392 closer to the ends 901, 902 of the photovoltaic device 900 than to the center of the photovoltaic device 900 may have a decreased amplitude in the periodic pattern of the serial interconnect relative to the serial interconnects 392 that are closer to the center of the photovoltaic device 900 than to the ends of the photovoltaic device 900. Each serial interconnect 392 may have a plurality of local peaks 3913. The intermediate longitudinal rovings 2203 may be positioned to underlie the local peaks 3913, so that each local peak 3913 has an underlying longitudinal roving 2203. Photovoltaic apparatus 700 also includes the rovings 220, which extends in the Y-direction, like the photovoltaic apparatus 500. In contrast to the photovoltaic apparatus 500, the photovoltaic apparatus 800 includes rovings 220 that are disposed to extend in the Y-direction and are positioned to underlie a centerline of the serial interconnects or a plurality of local peaks 3913 of the serial interconnects 392. In some embodiments, a roving 220 underlies at least half of the local peaks 3913 in a serial interconnect 392 of the photovoltaic device 800, and thus two rovings 220 can be used to support each serial interconnect 392.

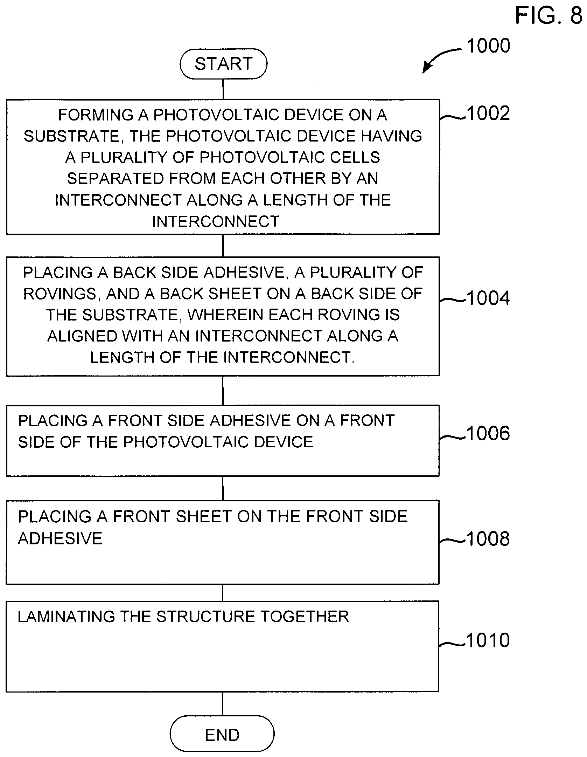

Figure 8 is a process flow diagram of a method 1000 for manufacturing one embodiment of a photovoltaic apparatus. The method 1000 is mainly described in reference to the photovoltaic apparatus 200 of Figure 1A, but the method 1000 may be adapted to manufacture any of the photovoltaic apparatuses described herein. Examples of adapting the method 1000 to form features of the different photovoltaic apparatuses described above are also provided below.

Referring to Figure 1 and Figure 8, at block 1002 the photovoltaic device 100 is formed on the substrate 110. The structure of the photovoltaic device 100 can be formed using series of deposition and scribing steps. The deposition steps are used to deposit the different layers of the photovoltaic device 100. For example, a sputtering process may be used to deposit the back contact layer 120 onto the substrate 110 to begin the formation of the photovoltaic device. The scribing steps can use mechanical or laser scribing to separate the layers in the separate photovoltaic cells from each other. For example, after the back contact layer 120 is deposited onto the substrate 110, a first laser scribing step can be used to separate the back contact layers 120 of the separate photovoltaic cells, such as the photovoltaic cells 101-104. This first scribing step can form the back contact grooves 121 of the serial interconnects 191. The deposition and scribing steps can then continue until the formation of the photovoltaic device 100 is complete. For example, second and third scribing steps can be used to remove material for forming the connecting groove 161 and the front contact groove 151 respectively. When the formation of the photovoltaic device 100 is complete, the individual photovoltaic cells are separated from each other by the serial interconnects 191 along the length of the serial interconnects 191 (i.e., the Y-direction in Figure 1). The serial interconnects 191 provide an electrical connection between the adjacent photovoltaic cells.

At block 1004, the back sheet 210, the back side adhesive 230 and the plurality of rovings 220 are placed on the back side of the substrate 110 (i.e., the side of the substrate 110 facing away from the photovoltaic device 100). Each roving 220 is aligned with at least a portion of a serial interconnect 191 along the length of that serial interconnect 191. In some embodiments, the rovings 220 may be aligned with a particular feature of the serial interconnect 191, such as the back contact groove 121. Additional rovings, such as the longitudinal rovings 2201-2203, may also be placed on the back side of the substrate 110 at this time. In one embodiment, the rovings, such as the rovings 220 and the longitudinal rovings 2201-2203, may already be arranged and aligned within the back side adhesive 230 to reduce the time used for completing this step. In one embodiment, the rovings are first aligned on the back side of the substrate 110 and then a sheet of the back side adhesive 230 and the back sheet 210 are placed over the rovings. In another embodiment, the rovings, such as the rovings 220, can be arranged on a sheet of the back side adhesive 230, and then the substrate with the photovoltaic device 100 are placed on top of and aligned to the rovings that are positioned on the back side adhesive 230 and the back sheet 210. In one example, features in the photovoltaic device 100 (e.g., serial interconnects 191) are aligned to the rovings in this step.

At block 1006, the front-side adhesive 240, for example formed as a sheet, is placed on a front side of the photovoltaic device 100, for example on the front contact layer 150 and over the busbars 170, 180. In some embodiments, the front-side adhesive 240 is placed on the structure including the photovoltaic device 100 before the back side adhesive 230. In other embodiments, the front side adhesive and the back side adhesive are added simultaneously to the structure including the photovoltaic device 100.

At block 1008, the front sheet 250 is placed on the front-side adhesive 240, such as on a sheet of the front-side adhesive 240.

At block 1010, the composite structure including the back sheet 210, the back side adhesive 230, the rovings 220 and any additional rovings, the substrate 110, the photovoltaic device 100, the busbars 170, 180 and other electrical connections, the front-side adhesive 240, and the front sheet 250 is laminated together. The laminating process can include heating the composite structure to promote the adhesion of the different components in the composite structure. For example, the heating may melt the front-side adhesive 240 and the back-side adhesive 230. In one embodiment, the structure is laminated together by passing the structure through a set of rollers, for example, after or while heating the composite structure.

In embodiments including an edge seal, the edge seal may be added before or after laminating the composite structure. For example, the edge seal 260 of the photovoltaic apparatus of Figure 2 may be added before laminating. In one embodiment, the edge seal 260 is added after the back sheet 210 is added and before the front sheet 250 is added.

In other embodiments, the edge seal may be added after laminating. For example, the edge seal 260f of the photovoltaic apparatus 300F of Figure 3F may be added as a flowable material after laminating.

Overall, the embodiments described above provide numerous advantages. The various types of rovings of the different photovoltaic apparatuses described above can be used to maintain spacing between the electrically active components (e.g., the busbars, serial interconnects, and sawtooth points of serial interconnects) of the photovoltaic devices and other components in the photovoltaic apparatus (e.g., the back sheet) and/or external objects (e.g., a metallic support for the photovoltaic apparatus or a structure on which the photovoltaic apparatus is mounted). Maintaining this spacing can prevent the occurrence and propagation of electrical arcs within the photovoltaic apparatus or between the photovoltaic apparatus and an external object. By using durable and substantially incompressible materials, such as fiber glass, to form the rovings, this spacing can be maintained during periods of mechanical strain, such as flexing, as well over long periods of time. Also, the rovings add to the overall structural integrity of the photovoltaic apparatus, which can help maintain alignment of components of the photovoltaic apparatus and prevent problems, such as delamination.

Moreover, the rovings may only be placed at the locations of the electrically active components, which is less expensive and lighter in weight than using, for example a sheet of fiber glass. The selective placement of the rovings also enables tuning of the flexibility and weight of the photovoltaic apparatus. Further advantages may be obtained from using the different types of edge seals discussed above in a photovoltaic apparatus to prevent the external environment from damaging the photovoltaic device. These edge seals may be strengthened by embedding one or more rovings within the edge seal (e.g., Figures 3D to 3F) and/or by covering additional surfaces with the edge seal, such as how edge seal 260f of Figure 3F extends from a lower surface of the back sheet 210 to a top surface of the front sheet 250.

Although embodiments are mainly described using a rectangular geometry, the disclosure is applicable to photovoltaic apparatuses and photovoltaic devices having other geometries, such as other polygonal shapes, circular shapes as well as irregular shapes. Furthermore, the different interconnects of a photovoltaic device may extend in multiple directions, such as any direction in the X-Y plane of the Figures 1 to 7 described above. In such embodiments, one or more rovings of the photovoltaic apparatus may be aligned with the length of each serial interconnect.

While the foregoing is directed to embodiments of the present disclosure, other and further embodiments of the disclosure may be devised without departing from the basic scope thereof, and the scope thereof is determined by the claims that follow.

## Claims

1. A photovoltaic apparatus (200) comprising:
a front sheet (250);
a back sheet (210);
a thin-film photovoltaic device (100) disposed between the front sheet (250) and the back sheet (210), the thin-film photovoltaic device (100) comprising:
an array of photovoltaic cells which array extends in a first direction (X-direction), wherein the array of photovoltaic cells comprises a first photovoltaic cell (101) and a second photovoltaic cell (102); and
a first serial interconnect (191) comprising a plurality of scribe lines (121, 151, 161) and having a length that extends in a second direction (Y-direction) perpendicular to first direction (X-direction), wherein the first serial interconnect (191) divides the solar cells to form the array of photovoltaic cells and connects the first photovoltaic cell (101) and the second photovoltaic cell (102), wherein the first photovoltaic cell (101) and the second photovoltaic cell (102) are electrically connected in series by the first serial interconnect (191);
and, **characterized in that** the photovoltaic apparatus further comprises: a spacing layer (215A) including a first roving formed of a bundle of fibers (e.g., 220₂) disposed between the first serial interconnect (191) and the back sheet (210), wherein the first roving (e.g., 220₂) has a length that is aligned with the length (Y-direction) of first serial interconnect (191).

2. The apparatus according to claim 1, wherein the first serial interconnect (191) comprises a back contact groove (121) that has a length that extends in the second direction, wherein the first roving (220₂) has a midline (e.g., 220₄ₘ) that is aligned with the length of the back contact groove (121).

3. The apparatus according to claim 2, wherein the spacing layer (220) extends beyond at least one side (1101, 1102, 1103, 1104) of the photovoltaic device (100) by about 1.5 mm to about 5 mm.

4. The apparatus according to claim 3, further comprising:
a busbar (170, 180) disposed between the photovoltaic device (100) and the front sheet (250); and
a foldover spacing layer (280) including one or more additional rovings (220) disposed between the busbar (170, 180) and an end (e.g., 402) of the photovoltaic apparatus (300A).

5. The apparatus according to claim 4, wherein the one or more additional rovings (220) of the foldover spacing layer (280) comprises one or more front-side rovings (220) between the busbar (170, 180) and the front sheet (250).

6. The apparatus according to claim 5, wherein the one or more front-side rovings (220) are disposed over from about 100 % to about 150 % of a width (181) of the busbar (170, 180).

7. The apparatus according to claim 1, further comprising:
a busbar (170, 180) disposed between the photovoltaic device (100) and the front sheet (250); and
at least one edge seal (260, 260b, 260d, 260e, 260f) having a portion disposed between the front sheet (250) and the back sheet (210) along an end of the apparatus in the first direction (X-direction).

8. The apparatus according to claim 7, wherein the edge seal comprises:
a base (260b3) extending in a third direction (Z-direction) from the back sheet (210) to the front sheet (250);
a first leg (260b1) extending from the base (260b3) towards a center of the photovoltaic apparatus in the first direction (X-direction), the first leg (260b1) disposed between the busbar (170, 180) and the front sheet (250); and
a second leg (260b2) extending from the base (260b3) towards a center of the photovoltaic apparatus in the first direction (X-direction), the first leg (260b1) disposed between the spacing layer (215A) and the back sheet (210).

9. The apparatus according to claim 7, wherein the edge seal at least partially surrounds an inner edge seal, the inner edge seal comprising:
a base (260b3) extending in a third direction (Z-direction) from the back sheet (210) to the front sheet (250);
a first leg (260b1) extending from the base (260b3) towards a center of the photovoltaic apparatus in the first direction (X-direction), the first leg (260b1) disposed between the busbar (170, 180) and the front sheet (250); and
a second leg (260b2) extending from the base (260b3) towards a center of the photovoltaic apparatus in the first direction (X-direction), the first leg (260b1) disposed between the spacing layer (215A) and the back sheet (210).

10. The apparatus according to claim 7, wherein:
the front sheet (250) has a first surface (251) facing the photovoltaic device (100) and second surface (252) opposite to the first surface (251);
the back sheet (210) has a first surface (211) facing the photovoltaic device (100) and second surface (212) opposite to the first surface (251); and
the edge seal extends from the first surface (211) of the back sheet (210) to the second surface (252) of the front sheet (250).

11. The apparatus according to claim 10, wherein the edge seal (260e) overlies the second surface (252) of the front sheet (250) to cover at least the underlying busbar (170, 180).

12. The apparatus according to claim 11, wherein the edge seal (260f) extends from the second surface (212) of the back sheet (210) to the second surface (252) of the front sheet (250).

13. The apparatus according to claim 1, wherein:
the first photovoltaic cell (101) and the second photovoltaic cell (102) extend in the second direction from a first side (1103) to a second side (1104) of the photovoltaic device (100);
the photovoltaic device extends from a first end (1101) to a second end (1102) in the first direction; and
a first longitudinal roving (2201) extends between the photovoltaic device (100) and the back sheet (210) along first side (1103) of the photovoltaic device (100), wherein the first longitudinal roving (2201) extends past the first end (1101) and the second end (1102) of the photovoltaic device (100) in the first direction (X-direction).

14. The apparatus according to claim 1, wherein at least one roving (221, 221e, 222) comprises glass fibers.

15. The apparatus according to claim 1, wherein at least one roving (221, 221e, 222) is disposed within a polymer material (230).

## Patentansprüche

1. Eine Photovoltaikvorrichtung (200), umfassend:
eine Vorderseite Folie (250);
eine Rückenseite Folie (210);
eine Dünnschicht-Photovoltaikvorrichtung (100), die zwischen der Vorderseite Folie (250) und der Rückenseite Folie (210) angeordnet ist, wobei die Dünnschicht-Photovoltaikvorrichtung (100) umfasst:
eine Anordnung von Photovoltaikzellen, die sich in eine erste Richtung (X-Richtung) erstreckt, wobei die Anordnung von Photovoltaikzellen eine erste Photovoltaikzelle (101) und eine zweite Photovoltaikzelle (102) umfasst; und
eine erste serielle Verbindung (191), die eine Vielzahl von Ritzlinien (121, 151, 161) umfasst und eine Länge aufweist, die sich in einer zweiten Richtung (Y-Richtung) senkrecht zur ersten Richtung (X-Richtung) erstreckt, wobei die erste serielle Verbindung (191) die Solarzellen teilt, um die Anordnung von Photovoltaikzellen zu bilden, und die erste Photovoltaikzelle (101) und die zweite Photovoltaikzelle (102) verbindet, wobei die erste Photovoltaikzelle (101) und die zweite Photovoltaikzelle (102) elektrisch in Serie durch die erste serielle Verbindung (191) geschaltet sind;
und, **dadurch gekennzeichnet, dass** die Photovoltaikvorrichtung ferner umfasst:
eine Abstandsschicht (215A) mit einem ersten Vorgarn, das aus einem Faserbündel (z.B. 220 2) gebildet ist, das zwischen der ersten seriellen Verbindung (191) und der Rückenseite Folie (210) angeordnet ist, wobei das erste Vorgarn (z.B. 220 2) eine Länge aufweist, die mit der Länge (Y-Richtung) der ersten seriellen Verbindung (191) ausgerichtet ist.

2. Die Vorrichtung nach Anspruch 1, wobei die erste serielle Verbindung (191) eine Rückkontaktnut (121) umfasst, die eine Länge aufweist, die sich in die zweite Richtung erstreckt, wobei der erste Vorgarn (220 2) eine Mittellinie (z.B. 220 4m) aufweist, die mit der Länge der Rückkontaktnut (121) ausgerichtet ist.

3. Die Vorrichtung nach Anspruch 2, wobei sich die Abstandsschicht (220) über mindestens eine Seite (1101, 1102, 1103, 1104) der Photovoltaikvorrichtung (100) um etwa 1,5 mm bis etwa 5 mm erstreckt.

4. Die Vorrichtung nach Anspruch 3, ferner umfassend:
eine Busbar (170, 180), die zwischen der Photovoltaikvorrichtung (100) und der Vorderseite Folie (250) angeordnet ist; und
eine umklappbare Abstandslage (280) mit einem oder mehreren zusätzlichen Vorgarn (220), die zwischen der Busbar (170, 180) und einem Ende (z.B. 402) der Photovoltaikvorrichtung (300A) angeordnet sind.

5. Die Vorrichtung nach Anspruch 4, wobei der eine oder die mehreren zusätzlichen Vorgarn (220) der Faltabstandslage (280) einen oder mehrere frontseitige Vorgarn (220) zwischen der Busbar (170, 180) und der Vorderseite Folie (250) umfasst.

6. Die Vorrichtung nach Anspruch 5, wobei die eine oder mehrere vordere Vorgarn (220) von etwa 100 % bis etwa 150 % einer Breite (181) der Busbar (170, 180) angeordnet sind.

7. Die Vorrichtung nach Anspruch 1, ferner umfassend:
eine Busbar (170, 180), die zwischen der Photovoltaikvorrichtung (100) und der Vorderseite Folie (250) angeordnet ist; und
mindestens eine Kantendichtung (260, 260b, 260d, 260e, 260e, 260f) mit einem Abschnitt, der zwischen der Vorderseite Folie (250) und der Rückenseite Folie (210) entlang eines Endes der Vorrichtung in der ersten Richtung (X-Richtung) angeordnet ist.

8. Die Vorrichtung nach Anspruch 7, worin die Kantendichtung umfasst:
eine Basis (260b3), die sich in einer dritten Richtung (Z-Richtung) von der Rückenseite Folie (210) zu der Vorderseite Folie (250) erstreckt;
einen ersten Schenkel (260b1), der sich von der Basis (260b3) zu einer Mitte der Photovoltaikvorrichtung in der ersten Richtung (X-Richtung) erstreckt, wobei der erste Schenkel (260b1) zwischen der Busbar (170, 180) und der Vorderseite Folie (250) angeordnet ist; und
einen zweiten Schenkel (260b2), der sich von der Basis (260b3) zu einer Mitte der Photovoltaikvorrichtung in der ersten Richtung (X-Richtung) erstreckt, wobei der erste Schenkel (260b1) zwischen der Zwischenschicht (215A) und der Rückenseite Folie (210) angeordnet ist.

9. Die Vorrichtung nach Anspruch 7, worin die Kantendichtung zumindest teilweise eine innere Kantendichtung umgibt, wobei die innere Kantendichtung umfasst:
eine Basis (260b3), die sich in einer dritten Richtung (Z-Richtung) von der Rückenseite Folie (210) zu der Vorderseite Folie (250) erstreckt;
einen ersten Schenkel (260b1), der sich von der Basis (260b3) zu einer Mitte der Photovoltaikvorrichtung in der ersten Richtung (X-Richtung) erstreckt, wobei der erste Schenkel (260b1) zwischen der Busbar (170, 180) und der Vorderseite Folie (250) angeordnet ist; und
einen zweiten Schenkel (260b2), der sich von der Basis (260b3) zu einer Mitte der Photovoltaikvorrichtung in der ersten Richtung (X-Richtung) erstreckt, wobei der erste Schenkel (260b1) zwischen der Zwischenschicht (215A) und der Rückenseite Folie (210) angeordnet ist.

10. Die Vorrichtung nach Anspruch 7, wobei:
die Vorderseite Folie (250) eine erste Oberfläche (251) aufweist, die der Photovoltaikvorrichtung (100) zugewandt ist, und eine zweite Oberfläche (252), die der ersten Oberfläche (251) gegenüberliegt;
die Rückenseite Folie (210) eine erste Oberfläche (211) aufweist, die der Photovoltaikvorrichtung (100) zugewandt ist, und eine zweite Oberfläche (212), die der ersten Oberfläche (251) gegenüberliegt; und
sich die Kantendichtung von der ersten Oberfläche (211) der Rückenseite Folie (210) bis zur zweiten Oberfläche (252) der Vorderseite Folie (250) erstreckt.

11. Die Vorrichtung nach Anspruch 10, wobei die Kantendichtung (260e) über der zweiten Oberfläche (252) der Vorderseite Folie (250) liegt, um mindestens die darunterliegende Busbar (170, 180) abzudecken.

12. Die Vorrichtung nach Anspruch 11, wobei sich die Kantendichtung (260f) von der zweiten Oberfläche (212) der Rückenseite Folie (210) bis zur zweiten Oberfläche (252) der Vorderseite Folie (250) erstreckt.

13. Die Vorrichtung nach Anspruch 1, wobei:
sich die erste Photovoltaikzelle (101) und die zweite Photovoltaikzelle (102) in der zweiten Richtung von einer ersten Seite (1103) zu einer zweiten Seite (1104) der Photovoltaikvorrichtung (100) erstrecken;
sich die Photovoltaikvorrichtung von einem ersten Ende (1101) zu einem zweiten Ende (1102) in die erste Richtung erstreckt; und
sich ein erstes Längsvorgarn (2201) zwischen der Photovoltaikvorrichtung (100) und der Rückenseite Folie (210) entlang der ersten Seite (1103) der Photovoltaikvorrichtung (100) erstreckt, wobei sich das erste Längsvorgarn (2201) über das erste Ende (1101) und das zweite Ende (1102) der Photovoltaikvorrichtung (100) in der ersten Richtung (X-Richtung) erstreckt.

14. Die Vorrichtung nach Anspruch 1, wobei mindestens ein Vorgarn (221, 221e, 222) Glasfasern umfasst.

15. Die Vorrichtung nach Anspruch 1, wobei mindestens ein Vorgarn (221, 221, 221e, 222) innerhalb eines Polymermaterials (230) angeordnet ist.

## Revendications

1. Appareil photovoltaïque (200) comprenant :
une feuille avant (250) ;
une feuille arrière (210) ;
un dispositif photovoltaïque (100) à couche mince disposé entre la feuille avant (250) et la feuille arrière (210), le dispositif photovoltaïque à couche mince (100) comprenant :
un réseau de cellules photovoltaïques, lequel réseau s'étend dans une première direction (direction X), où le réseau de cellules photovoltaïques comprend une première cellule photovoltaïque (101) et une seconde cellule photovoltaïque (102) ; et
une première interconnexion en série (191) comprenant une pluralité de lignes de scribes (121, 151, 161) et ayant une longueur qui s'étend dans une seconde direction (direction Y) perpendiculaire à la première direction (direction X), où la première interconnexion en série (191) divise les cellules solaires pour former le réseau de cellules photovoltaïques et relie la première cellule photovoltaïque (101) et la seconde cellule photovoltaïque (102), où la première cellule photovoltaïque (101) et la seconde cellule photovoltaïque (102) sont reliées en série par la première interconnexion en série (191), électriquement ; et, **caractérisé en ce que** l'appareil photovoltaïque comprend en outre :
une couche d'espacement (215A) comprenant une première mèche formée d'un faisceau de fibres (220₂) disposé entre la première interconnexion en série (191) et la feuille arrière (210), où la première mèche (220₂) a une longueur qui est alignée sur la longueur (direction Y) de la première interconnexion en série (191).

2. Appareil selon la revendication 1, où la première interconnexion en série (191) comprend une rainure de contact arrière (121) qui a une longueur qui s'étend dans la seconde direction, où la première mèche (220₂) a une ligne médiane (220₄ₘ) qui est alignée avec la longueur de la rainure de contact arrière (121).

3. Appareil selon la revendication 2, où la couche d'espacement (220) s'étend au-delà d'au moins un côté (1101, 1102, 1103, 1104) du dispositif photovoltaïque (100) d'environ 1,5 mm à environ 5 mm.

4. Appareil selon la revendication 3, comprenant en outre :
une busbar (170, 180) disposée entre le dispositif photovoltaïque (100) et la feuille avant (250) ; et
une couche d'espacement repliable (280) comprenant une ou plusieurs mèches supplémentaires (220) disposées entre le busbar (170, 180) et une extrémité (402) de l'appareil photovoltaïque (300A).

5. Appareil selon la revendication 4, où la ou les mèches supplémentaires (220) de la couche d'espacement de pliage (280) comprennent une ou plusieurs mèches avant (220) entre la busbar (170, 180) et la feuille avant (250).

6. Appareil selon la revendication 5, où la ou les mèches avant (220) sont disposées sur environ 100 % à environ 150 % d'une largeur (181) de la busbar (170, 180).

7. Appareil selon la revendication 1, comprenant en outre :
une busbar (170, 180) disposée entre le dispositif photovoltaïque (100) et la feuille avant (250) ; et
au moins un joint de bordure (260, 260b, 260d, 260e, 260e, 260f) ayant une partie disposée entre la feuille avant (250) et la feuille arrière (210) le long d'une extrémité de l'appareil dans la première direction (direction X).

8. Appareil selon la revendication 7, dans lequel le joint de bordure comprend :
une base (260b3) s'étendant dans une troisième direction (direction Z) de la feuille arrière (210) à la feuille avant (250) ;
une première branche (260b1) s'étendant de la base (260b3) vers un centre de l'appareil photovoltaïque dans la première direction (direction X), la première branche (260b1) étant disposée entre le busbar (170, 180) et la feuille avant (250) ; et
une deuxième branche (260b2) s'étendant de la base (260b3) vers un centre de l'appareil photovoltaïque dans la première direction (direction X), la première branche (260b1) étant disposée entre la couche de séparation (215A) et la feuille arrière (210).

9. Appareil selon la revendication 7, dans lequel le joint de bord entoure au moins partiellement un joint de bord intérieur, le joint de bord intérieur comprenant :
une base (260b3) s'étendant dans une troisième direction (direction Z) de la feuille arrière (210) à la feuille avant (250) ;
une première branche (260b1) s'étendant de la base (260b3) vers un centre de l'appareil photovoltaïque dans la première direction (direction X), la première branche (260b1) étant disposée entre le busbar (170, 180) et la feuille avant (250) ; et
une deuxième branche (260b2) s'étendant de la base (260b3) vers un centre de l'appareil photovoltaïque dans la première direction (direction X), la première branche (260b1) étant disposée entre la couche de séparation (215A) et la feuille arrière (210).

10. Appareil selon la revendication 7, où :
la feuille avant (250) présente une première surface (251) tournée vers le dispositif photovoltaïque (100) et une seconde surface (252) opposée à la première surface (251) ;
la feuille arrière (210) présente une première surface (211) tournée vers le dispositif photovoltaïque (100) et une seconde surface (212) opposée à la première surface (251) ; et
le joint de bord s'étend de la première surface (211) de la feuille arrière (210) à la deuxième surface (252) de la feuille avant (250).

11. Appareil selon la revendication 10, où le joint de bord (260e) recouvre la seconde surface (252) de la feuille avant (250) pour couvrir au moins la busbar sous-jacent (170, 180).

12. Appareil selon la revendication 11, où le joint de bord (260f) s'étend de la deuxième surface (212) de la feuille arrière (210) à la deuxième surface (252) de la feuille avant (250).

13. Appareil selon la revendication 1, dans lequel :
la première cellule photovoltaïque (101) et la deuxième cellule photovoltaïque (102) s'étendent dans la deuxième direction d'un premier côté (1103) à un deuxième côté (1104) du dispositif photovoltaïque (100) ;
le dispositif photovoltaïque s'étend d'une première extrémité (1101) à une deuxième extrémité (1102) dans la première direction ; et
une première mèche longitudinale (2201) s'étend entre le dispositif photovoltaïque (100) et la feuille arrière (210) le long du premier côté (1103) du dispositif photovoltaïque (100), la première mèche longitudinale (2201) s'étendant au-delà de la première extrémité (1101) et la deuxième extrémité (1102) du dispositif photovoltaïque (100) dans la première direction (direction X).

14. Appareil selon la revendication 1, dans lequel au moins une mèche (221, 221e, 222) comprend des fibres de verre.

15. Appareil selon la revendication 1, dans lequel au moins une mèche (221, 221e, 222) est disposée dans un matériau polymère (230).
